# EUROPEAN PATENT APPLICATION

(11) **EP 2 090 400 A1**
(43) Date of publication of application: **19.08.2009**
(21) Application number: 07807270.9
(22) Date of filing: 13.09.2007
(51) Int. Cl.: B24B 37/00, C09K 3/14, H01L 21/304

(54) **CMP POLISHING AGENT, ADDITIVE SOLUTION FOR CMP POLISHING AGENT, AND METHOD FOR POLISHING SUBSTRATE BY USING THE POLISHING AGENT AND THE ADDITIVE SOLUTION**

(30) Priority: 15.09.2006 JP 2006250822; 18.06.2007 JP 2007160081
(71) Applicant: Hitachi Chemical Company, Ltd., Tokyo 163-0449 (JP)
(72) Inventor: FUKASAWA, Masato, Ibaraki 317-8555 (JP); YAMAGISHI, Chiaki, Ibaraki 317-8555 (JP); KIMURA, Tadahiro, Ibaraki 317-8555 (JP); AKUTSU, Toshiaki, Ibaraki 317-8555 (JP)
(74) Representative: HOFFMANN EITLE
(86) International application number: PCT/JP2007/067863
(87) International publication number: WO 2008/032794

(57) **Abstract**

The invention relates to a CMP polishing slurry containing cerium oxide particles, a dispersing agent, a water-soluble polymer and water, wherein the water-soluble polymer includes a polymer obtained by polymerizing a monomer including at least one of a carboxylic acid having an unsaturated double bond and a salt thereof, using a reducing inorganic acid salt and oxygen as a redox polymerization initiator; an additive liquid for CMP polishing slurry; and substrate-polishing processes using the same. This makes it possible to polish a silicon oxide film effectively in a CMP technique for planarizing an interlayer dielectric, a BPSG film or a shallow trench isolating insulated film.

## Description

### Technical Field

The present invention relates to a CMP polishing slurry, and an additive liquid for CMP polishing slurry that are each used in the step of planarizing a substrate surface, the step being a semiconductor-element-producing technique, in particular, the step of planarizing an interlayer dielectric or a BPSG (silicon dioxide film doped with boron and phosphorus) film, the step of forming a shallow trench isolation, or other steps.

### Background Art

About the present ultra large scale integrated circuits, packaging density thereof has tended to be made higher. Thus, various finely working techniques have been researched and developed. The existing design rule is already related to a sub-half-micron order. One out of techniques which have been developed to satisfy such a severe requirement that a finer scale should be realized is CMP (chemical mechanical polishing). This technique makes it possible to planarize a layer which is to be exposed to light completely in the process of producing a semiconductor device, decrease a burden onto light-exposure technique, and make the yield stable. For this reason, the technique is a technique essential, for example, for planarizing an interlayer dielectric or a BPSG film, or attaining shallow trench isolation or the like.

Conventionally, in the process of producing a semiconductor device, a fumed silica based polishing slurry has been generally investigated as a CMP polishing slurry for planarizing an inorganic insulated film layer, such as a silicon oxide insulated film. The silicon oxide insulated film is formed by plasma-CVD (Chemical Vapor Deposition), low-pressure CVD, or some other method. The fumed silica based polishing agent is produced by growing grains of silica in a way of decomposing silicon tetrachloride thermally or in some other way, and then adjusting the pH of the resultant. However, such a silica based polishing slurry is low in polishing rate, and further the aggregation of particles is easily caused. Thus, the polishing rate, polished scratches and the reproducibility of planarization performance have been issues.

In conventional CMP technique for planarizing an interlayer dielectric, the polishing rate depends largely on the pattern of the film to be polished on a substrate. As a result thereof, in accordance with the level of a difference between pattern densities or a difference between pattern sizes, the rate of polishing convex regions is largely varied and further the polishing of concave regions also advances. For this reason, there remains a technical problem that the whole of the wafer surface cannot be planarized at a high level.

According to the CMP technique for planarizing an interlayer dielectric, it is necessary to end the polishing of the interlayer dielectric in the middle of the dielectric. A process-controlling method of controlling the polishing amount in accordance with the polishing time is generally performed.

However, the polishing rate is remarkably varied in accordance with not only a change in the form of stages of the pattern but also the state of the polishing cloth and others. Thus, there is a problem that the control of the process is difficult. In the generation of the design rule of a 0.5 µm or more scale, LOCOS (local oxidation of silicon) was used in order to isolate elements in integrated circuits.

Thereafter, a technique of making element-isolating width narrower has been required as the working dimension has become finer. Thus, shallow trench isolation has been used. In the shallow trench isolation, CMP is used in order to remove an extra silicon oxide film formed on a substrate. In order to stop the polishing, a stopper film small in removal rate by polishing is formed beneath the silicon oxide film. For the stopper film, silicon nitride or the like is used. It is desired that the ratio of the removal rate of the silicon oxide film to that of the stopper film is large.

In the meantime, a cerium oxide polishing slurry is used as a surface polishing slurry for a photomask, a lens or other glass pieces. Cerium oxide particles are lower in hardness than silica particles or alumina particles; accordingly, a surface to be polished is not easily scratched. Thus, the polishing slurry is useful for mirror-polishing for finishing. Moreover, the polishing slurry has an advantage that the slurry is larger in polishing rate than silica polishing slurries. In recent years, a CMP polishing slurry, for a semiconductor, wherein high-purity cerium oxide abrasive grains are used has been used. The technique is disclosed in, for example, Japanese Patent Application Laid-Open (JP-A) No. 10-106994.

Further, in order to control polishing rate of a cerium oxide polishing slurry and improve global planarization, it is known that additive is added. The technique is disclosed in, for example, JP-A No. 8-22970.

### Disclosure of the Invention

However, the cerium oxide polishing slurry for polishing a glass surface is low in the capability of planarizing a semiconductor substrate having a surface having irregularities. Thus, the slurry cannot be used, as it is, as a polishing slurry for a semiconductor. About the polishing slurry using cerium oxide, there is also a problem that the control of polishing-process and high-rate polishing are incompatible with each other.

An object of the invention is to solve the problems in the technique of planarizing an interlayer dielectric, a BPSG film or a shallow trench isolating insulated film, and provide a CMP polishing slurry and an additive liquid for CMP polishing slurry that make it possible to polish a silicon oxide film effectively, and substrate-polishing processes using the same.

The invention relates to (1) a CMP polishing slurry, containing water-soluble polymer and water, wherein the water-soluble polymer includes a polymer obtained by polymerizing a monomer including at least one of a carboxylic acid having an unsaturated double bond and a salt thereof, using a reducing inorganic acid salt and oxygen as a redox polymerization initiator.

The invention also relates to (2) the CMP polishing slurry according to item (1), wherein the reducing inorganic acid salt is a sulfite.

The invention also relates to (3) the CMP polishing slurry according to item (1) or (2), wherein the blend amount of the water-soluble polymer is 0.01 part or more by mass to 5 parts or less by mass for 100 parts by mass of the CMP polishing slurry.

The invention also relates to (4) the CMP polishing slurry according to any one of items (1) to (3), wherein the weight-average molecular weight of the water-soluble polymer is 200 or more to 50,000 or less.

The invention also relates to (5) the CMP polishing slurry according to any one of items (1) to (4), wherein at least one of the dispersing agent and the water-soluble polymer is a compound having in the molecule thereof no nitrogen.

The invention also relates to (6) the CMP polishing slurry according to any one of items (1) to (5), wherein the nitrogen content in the polishing slurry is 10 ppm or less.

The invention also relates to (7) the CMP polishing slurry according to item (5) or (6), which is used to detect the end point of polishing on the basis of the generation of ammonia.

The invention also relates to (8) the CMP polishing slurry according to any one of items (1) to (7), wherein the carboxylic acid having an unsaturated double bond and the salt thereof include at least one selected from acrylic acid, methacrylic acid, and salts thereof.

The invention also relates to (9) the CMP polishing slurry according to any one of items (1) to (7), wherein the carboxylic acid having an unsaturated double bond and the salt thereof include acrylic acid or a salt thereof.

The invention also relates to (10) the CMP polishing slurry according to any one of items (1) to (7), wherein the carboxylic acid having an unsaturated double bond and the salt thereof are acrylic acid or a salt thereof.

The invention also relates to (11) an additive liquid for CMP polishing slurry, including a water-soluble polymer and water, wherein the water-soluble polymer includes a polymer obtained by polymerizing a monomer including at least one of a carboxylic acid having an unsaturated double bond and a salt thereof, using a reducing inorganic acid salt and oxygen as a redox polymerization initiator.

The invention also relates to (12) the additive liquid for CMP polishing slurry according to item (11), wherein the reducing inorganic acid salt is a sulfite.

The invention also relates to (13) the additive liquid for CMP polishing slurry according to item (11) or (12), wherein the weight-average molecular weight of the water-soluble polymer is 200 or more to 50,000 or less.

The invention also relates to (14) the additive liquid for CMP polishing slurry according to any one of items (11) to (13), wherein the carboxylic acid having an unsaturated double bond and the salt thereof include at least one selected from acrylic acid, methacrylic acid, and salts thereof.

The invention also relates to (15) the additive liquid for CMP polishing slurry according to any one of items (11) to (13), wherein the carboxylic acid having an unsaturated double bond and the salt thereof include acrylic acid or a salt thereof.

The invention also relates to (16) the additive liquid for CMP polishing slurry according to any one of items (11) to (13), wherein the carboxylic acid having an unsaturated double bond and the salt thereof are acrylic acid or a salt thereof.

The invention also relates to (17) a substrate-polishing process, wherein a substrate on which a film to be polished is formed is pushed and pressed against a polishing cloth of a polishing table, and a CMP polishing slurry as recited in any one of items (1) to (10) is supplied to between the film to be polished and the polishing cloth while the substrate and the polishing table are relatively moved, thereby polishing the film to be polished.

The invention also relates to (18) a substrate-polishing process, wherein a substrate on which a film to be polished is formed is pushed and pressed against a polishing cloth of a polishing table, a cerium oxide containing cerium oxide particles, a dispersing agent and water is mixed with an additive liquid for CMP polishing slurry as recited in any one of items (11) to (16) to yield a CMP polishing slurry, and the CMP polishing slurry is supplied to between the film to be polished and the polishing cloth while the substrate and the polishing table are relatively moved, thereby polishing the film to be polished.

The invention also relates to (19) the substrate-polishing process according to item (17) or (18), including the step of detecting ammonia generated by polishing a nitride, thereby deciding the end point of the polishing.

The disclosure of the present application is related to the subject matter described in Japanese Patent Application No. 2006-250822 filed on September 15, 2006, and the content disclosed therein is incorporated herein by reference.

### Best Mode for Carrying Out the Invention

A silicon oxide film is generally formed by plasma CVD (P-TEOS) using TEOS (tetra ethoxy silane) as a raw material, a method of causing TEOS to react with ozone (O₃-TEOS), high-density plasma CVD using monosilane (SiH₄) as a raw material (HDP-SiO), or some other method. A cerium oxide polishing slurry used to polish this silicon oxide film makes it possible to attain polishing at a higher rate as the diameter of primary particles therein is larger and further the crystal strain is smaller, that is, the crystallinity is better. However, polished scratches tend to be more easily generated.

Thus, about the cerium oxide particles used in the invention, the cerium oxide crystallite diameter is preferably 5 nm or more to 300 nm or less although the producing process thereof is not limited.

In general, cerium oxide is obtained by oxidizing a cerium compound of a carbonate, nitrate, sulfate or oxalate. In the invention, the method for producing cerium oxide powder may be firing, or an oxidizing method using hydrogen peroxide or the like. The firing temperature is preferably 350°C or higher to 900°C or lower.

The cerium oxide particles produced by the method are in an aggregated state; therefore, it is preferred that the particles are mechanically pulverized. The method for the pulverizing is preferably a dry pulverizing method using a jet mill or the like, or a wet pulverizing method using a planet bead mill or the like.
Jet mills are described in, for example, Journal of the Society of Chemical Engineering (The Society of Chemical Engineers, Japan), vol. 6, No. 5 (1980), pp. 527-532.

The method for dispersing such cerium oxide particles into water, which is a main dispersion medium, may be dispersing treatment using an ordinary agitator, or the use of a homogenizer, an ultrasonic dispersing machine, a wet ball mill or the like.

The method for making the cerium oxide dispersed by the method into finer particles may be a sedimentation classification method of allowing the cerium oxide dispersed solution to stand still for a long time to sediment large particles and then pumping the supernatant up; besides, the method may be the use of a high-pressure homogenizer for causing the cerium oxide particles in the dispersion medium to collide with each other under a high pressure.

The CMP polishing slurry of the invention is obtained, for example, by dispersing a composition composed of cerium oxide particles having the characteristics, a dispersing agent, and water, and further adding thereto an additive.
The concentration of the cerium oxide particles is not limited, and the concentration is preferably in the range of 0.5% or more by mass to 20% or less by mass since the dispersion solution is easily handled.

The average particle diameter of the cerium oxide particles in the thus-produced CMP polishing slurry is preferably from 0.01 to 1.0 µm. If the average particle diameter of the cerium oxide particles is less than 0.01 µm, the polishing rate becomes too low. If the average particle diameter is more than 1.0 µm, scratches are easily generated in a polished film.

In the invention, the average particle diameter of the cerium oxide particles is represented by the central value (D50) of the particle diameters measured with a laser scattering type particle size distribution meter.

The dispersing agent is preferably, for example, a polymeric dispersing agent containing an acrylic acid salt as a copolymerized component.

Two or more dispersing agents may be used which include: at least one selected from water-soluble anionic dispersing agents, water-soluble nonionic dispersing agents, water-soluble cationic dispersing agents, and water-soluble ampholytic dispersing agents; and a polymeric dispersing agent containing an acrylic acid salt as a copolymerized component.

Examples of the water-soluble anionic dispersing agents include triethanolamine laurylsulfate, ammonium laurylsulfate, polyoxyethylene alkyl ether triethanolamine sulfate, and especial polycarboxylic acid type polymeric dispersing agents. Examples of the water-soluble nonionic dispersing agents include polyoxyethylene lauryl ether, polyoxyethylene cetyl ether, polyoxyethylene steary ether, polyoxyethylene oleyl ether, polyoxyethylene higher alcohol ether, polyoxyethylene octyl phenyl ether, polyoxyethylene nonyl phenyl ether, polyoxyethylene derivatives, polyoxyethylene sorbitan monolaurate, polyoxyethylene sorbitan monopalmitate, polyoxyethylene sorbitan monostearate, polyoxyethylene sorbitan tristearate, polyoxyethylene sorbitan monooleate, polyoxyethylene sorbitan trioleate, polyoxyethylene sorbit tetraoleate, polyethylene glycol monolaurate, polyethylene glycol monostearate, polyethylene glycol distearate, polyethylene glycol monooleate, polyoxyethylene alkylamine, polyoxyethylene hardened castor oil, and alkylalkanolamide. Examples of the water-soluble cationic dispersing agents include polyvinylpyrrolidone, coconutamine acetate, and stearylamine acetate. Examples of the water-soluble ampholytic dispersing agents include laurylbetaine, stearylbetaine, lauryldimethylamine oxide, and 2-alkyl-N-carboxymethyl-N-hydroxyethylimidazolinium betaine.

The blend amount of the dispersing agent is preferably 0.01 parts or more by mass to 2.0 parts or less by mass for 100 parts by mass of the cerium oxide particles from the viewpoint of the dispersibility of the particles in the polishing slurry, the prevention of the sedimentation thereof, and the relationship between polished scratches and the blend amount of the dispersing agent.

The molecular weight of the dispersing agent is preferably from 100 to 50,000, more preferably from 1,000 to 10,000. If the molecular weight of the dispersing agent is less than 100, a sufficient polishing rate is not obtained when a silicon oxide film or silicon nitride film is polished. If the molecular weight of the dispersing agent is more than 50, 000, the viscosity of the agent becomes high so that the storage stability of the CMP polishing slurry tends to fall. In the case of using it for ammonia-detection, which will be described later, it is preferred that the dispersing agent is a dispersing agent containing no nitrogen or the use amount of the dispersing agent that contains nitrogen is decreased.

As described in JP-A No. 2000-031102, it was found out that: when an oxide SiO₂ on a nitride Si₃N₄ is polished in a high pH state in the presence of potassium hydroxide, a reaction (1) described below is caused; and when the nitride Si₃N₄ as a stopper film is polished, a reaction (2) described below is caused. When it reaches the interface between the two, the chemical reaction (2) is caused to generate ammonia (NH₃). When the ammonia incorporated into the waste of the polishing slurry is detected, the end point of the polishing can be decided.

(1) SiO₂ + 2KOH + H₂O → K₂SiO₃ + 2H₂O

(2) Si₃N₄ + 6KOH + 3H₂O → 3K₂SiO₃ + 4NH₃

When the pH is low, the sensitivity of the detection is lowered by the effect of NH₄+; thus, in such a case, potassium hydroxide is afterwards added to the polishing slurry waste to adjust the pH into about 10, whereby the sensitivity can be made high. Specifically, when an alkali is added to the slurry waste containing, for example, nitride-film-polished chips to make the pH high, ammonia can be detected according to the reactions. The alkali other than potassium hydroxide may be a metal hydroxide containing no nitrogen. Such a hydroxide soluble in water, such as sodium hydroxide, calcium hydroxide or barium hydroxide, may be used. The range of the pH is preferably 7 or more, more preferably 8 or more since the detecting sensitivity of ammonia is high so that the end point is clearly detected.

Accordingly, in a case where ammonia, an ammonium salt or any other nitrogen compound is contained in the polishing slurry, the polishing end cannot be detected with a high sensitivity by the effect of interference. Thus, the case is not preferred. In order to restrain this interference, the amount of nitrogen in the polishing slurry is preferably 10 ppm or less, more preferably 1 ppm or less.

For this purpose, the dispersing agent and/or a water-soluble polymer that will be described later is/are (each) preferably a compound containing in the molecule thereof no nitrogen. In general, the blend amount of the water-soluble polymer is larger than that of the dispersing agent; it is therefore more preferred that the water-soluble polymer is a compound containing in the molecule thereof no nitrogen.

The CMP polishing slurry of the invention is preferable for detecting the end point by detecting ammonia when the nitrogen content in the polishing slurry is made low as described above. However, the polishing slurry may be used in a method for detecting the end point by monitoring a change in the torque current value of a polishing table, or other methods.

The CMP polishing slurry of the invention also contains a polymer obtained by polymerizing a monomer including at least one of a carboxylic acid having an unsaturated double bond and a salt thereof (the monomer may be referred to as the "carboxylic acid type monomer" hereinafter). This polymer is a water-soluble polymer obtained by polymerizing the monomer using a reducing inorganic acid salt and oxygen as a redox polymerization initiator. The weight-average molecular weight thereof is preferably 200 or more; however, the molecular weight is not particularly limited.

Examples of the carboxylic acid containing an unsaturated double bond include acrylic acid, methacrylic acid, crotonic acid, itaconic acid, fumaric acid, maleic acid, citraconic acid, mesaconic acid, tiglic acid, and 2-trifluoromethylacrylic acid. These may be used in combination of two or more thereof. Examples of salts of these carboxylic acids include ammonium salts, potassium salts and alkylamine salts thereof.

The polymer may be a polymer obtained by copolymerizing the carboxylic acid type monomer with a radical-polymerizable monomer such as vinyl alcohol, acrylonitrile, vinylpyrrolidone, vinylpyridine, a C₁-C₁₈ acrylic acid ester, a C₁-C₁₈ methacrylic acid ester, acrylamide, N,N-dimethylacrylamide, N,N-diethylacrylamide, or N-isopropylacrylamide.

The carboxylic acid type monomer more preferably includes at least one selected from acrylic acid, methacrylic acid, and salts thereof in light of solubility and polishing property. The monomer more preferably includes acrylic or a salt thereof, and is even more preferably acrylic acid or a salt thereof.

In the case of using it for ammonia-detection, it is preferred that the radical-polymerizable monomer is a monomer containing no nitrogen or the copolymerization amount of the monomer that contains nitrogen is decreased.

The redox initiator combined with oxygen is not particularly limited as far as the initiator is a reducing inorganic acid salt. Preferred examples thereof include ammonium hydrogensulfite, ammonium sulfite, potassium hydrogensulfite, potassium sulfite, potassium disulfite, sodium hydrogensulfite, sodium sulfite, sodium disulfite, calcium sulfite, and barium sulfite. Sulfites are particularly preferred. As oxygen, air may be used. The method for polymerizing the carboxylic acid type monomer using oxygen and a sulfite as a redox polymerization initiator is described in, for example, JP-A No. 56-055407, or Polymer Preprints, Japan, vol. 36, No. 6, 1601-1603 (1987). For example, an acrylic acid salt and sodium hydrogensulfite are added into an aqueous reaction solvent, air is continuously blown into the solution so as to give fine air bubbles, and the temperature is kept at 80°C or lower to carry out aqueous-solution polymerization, thereby yielding a polymer.

In the polishing slurry of the invention, a water-soluble polymer other than the polymer may be used together as far as the advantageous effects of the invention are not hindered.

Examples thereof include polysaccharides such as alginic acid, pectic acid, carboxymethylcellulose, agar, curdlan, and pullulan; and polycarboxylic acids and salts thereof, such as polyaspartic acid, polyglutamic acid, polylysine, polymalic acid, polyamic acid, poly(p-styrenecarboxylic acid), polyacrylamide, aminopolyacrylamide, ammonium polyamiate, sodium polyamiate, and polyglyoxylic acid; and vinyl polymers, such as polyvinyl alcohol, polyvinylpyrrolidone, and polyacrolein.

These water-soluble polymers may be used alone or in combination of two or more thereof. The blend amount thereof is preferably in the range of 0.01 part or more by mass to 5 parts or less by mass, more preferably in the range of 0.2 part or more by mass to 3 parts or less by mass for 100 parts by mass of the polishing slurry. In particular, the blend amount of the polymer is preferably 0.01 parts or more by mass to 5 parts or less by mass, more preferably 0.02 part or more by mass to 2 parts or less by mass, even more preferably 0.05 part or more by mass to 1 part or less by mass for 100 parts by mass of the polishing slurry.

The weight-average molecular weight of the water-soluble polymer is not particularly limited, and is preferably 200 or more to 50,000 or less, more preferably 500 or more to 30,000 or less.

If the blend amount of the water-soluble polymer is too small, a high-rate polishing property tends not to be obtained. If the amount is too large, the fluidity tends to fall because the slurry is gelatinized. In the case of using it for ammonia-detection, it is preferred that the water-soluble polymer is a polymer containing no nitrogen or the use amount of the water-soluble polymer that contains nitrogen is decreased.

The water-soluble polymer may be used also as the dispersing agent.

The polishing slurry of the invention may be stored as, for example, a two-component type CMP polishing slurry wherein a cerium oxide slurry composed of cerium oxide particles, a dispersing agent and water, and an additive liquid composed of a water-soluble polymer and water are separated from each other.

That is to say, the additive liquid of the invention for CMP polishing slurry contains a water-soluble polymer and water, wherein the water-soluble polymer includes a polymer obtained by polymerizing the carboxylic acid type monomer, using a reducing inorganic acid salt and oxygen as a redox polymerization initiator.

Whether the polishing slurry of the invention is stored as a two-component type CMP polishing slurry composed of a cerium oxide slurry and the additive liquid for CMP polishing slurry or stored as a one-component type polishing slurry containing a water-soluble polymer beforehand, stable properties are obtained. In the case of storing the polishing slurry as a two-component type polishing slurry, the planarization property and the polishing rate can be adjusted by arbitrarily varying the proportion between these two liquid components. In the case of performing polishing with the two-component type polishing slurry, the following method is adopted: a method (1) of supplying the additive liquid for CMP polishing slurry and the cerium oxide slurry separately from each other onto a polishing table and mixing the two on the polishing table, a method (2) of mixing the additive liquid for CMP polishing slurry with the cerium oxide slurry just before the polishing, or a method (3) of sending the additive liquid for CMP polishing slurry and the cerium oxide slurry through pipes different from each other, jointing these pipes to each other, and mixing the two with each other just before an exit of the supplying pipe so as to supply the mixture onto a polishing table.

In a first substrate-polishing process of the invention, a substrate on which a film to be polished is formed is pushed and pressed against a polishing cloth of a polishing table, and the CMP polishing slurry of the invention is supplied to between the film to be polished and the polishing cloth while the substrate and the polishing table are relatively moved, thereby polishing the film to be polished.

In a second substrate-polishing process of the invention, a substrate on which a film to be polished is formed is pushed and pressed against a polishing cloth of a polishing table, a cerium oxide slurry containing cerium oxide particles, a dispersing agent and water is mixed with the additive liquid of the invention for CMP polishing slurry to yield a CMP polishing slurry, and the CMP polishing slurry is supplied to between the film to be polished and the polishing cloth while the substrate and the polishing table are relatively moved, thereby polishing the film to be polished.

The substrate having a film to be polished may be a substrate wherein a silicon oxide film layer or silicon nitride film layer is formed on a semiconductor substrate, that is, a semiconductor substrate at the stage when circuit elements and a wiring pattern are formed, a semiconductor substrate at the stage when circuit elements are formed, or some other semiconductor substrate. By polishing such a silicon oxide film layer or silicon nitride film layer formed on such a semiconductor substrate with the CMP polishing slurry, unevenness of the surface of the silicon oxide film layer can be cancelled to planarize make the surface of the semiconductor substrate over the whole thereof.

The polishing slurry may be used to attain shallow trench isolation. In order to use the polishing slurry to attain shallow trench isolation, it is preferred that the ratio between the silicon-oxide-film-polishing rate and the silicon-nitride-film-polishing rate, or the ratio of the silicon-oxide-film-polishing rate to the silicon-nitride-film-polishing rate is 10 or more.

If this ratio is less than 10, the difference between the silicon-oxide-film-polishing rate and the silicon-nitride-film-polishing rate is small. Thus, when shallow trench isolation is performed, the polishing is not easily stopped at a predetermined position. In a case where this ratio is 10 or more, the silicon-nitride-film-polishing rate becomes smaller so that the polishing is easily stopped. Thus, this case is more preferred for shallow trench isolation.

In order to use the polishing slurry to attain shallow trench isolation, it is preferred that scratches are less generated at the time of polishing therefor.

The following will describe the polishing processes, giving, as an example, a case of a semiconductor substrate on which an inorganic insulated layer is formed.

In the polishing processes of the invention, the polishing machine for the polishing may be an ordinary polishing machine having a holder for holding a semiconductor substrate, and a polishing table to which a polishing cloth (pad) can be fitted, and a motor the rotation number of which is variable and others are fitted. For example, a polishing machine (model number: EPO-111) manufactured by Ebara Corp. may be used. The polishing cloth may be an ordinary nonwoven cloth, a foamed polyurethane, a porous fluorine-contained resin, or the like. The cloth is not particularly limited.

It is also preferred that a groove is made in the polishing cloth so as to collect the CMP polishing slurry therein.

Conditions for the polishing are not particularly limited; the rotational speed of the table is preferably a low rotation of 200 min⁻¹ or less in order for the semiconductor substrate not to spin out, and the pressure (working load) applied to the semiconductor substrate is 1 kg/cm² (98 kPa) or less in order for scratches not to be generated after the polishing.

During the polishing, the CMP polishing slurry is continuously supplied to the polishing cloth with a pump or the like. The amount of this supply is not limited, and is preferably set in such a manner that the surface of the polishing cloth is constantly covered with the CMP polishing slurry.

It is preferred to dry the polished semiconductor substrate after the substrate is sufficiently washed with flowing water and then water droplets adhering onto the substrate are spun out by use of a spin drier and the like. When the inorganic insulated layer, which is a film to be polished, is polished with the polishing slurry as described above, unevenness of the surface is cancelled to give a smooth surface as the overall surface of the semiconductor substrate. After shallow strenches planarized in this way are formed, aluminum wiring is formed on the silicon oxide insulated film layer. Between pieces of the wiring and on the wiring, a silicon oxide insulated film is again formed by the process. Thereafter, the CMP polishing slurry is used to polish the film in the same manner. When this step is repeated predetermined times, a semiconductor substrate wherein the number of layers is a desired number can be produced.

In order to attain global planarization of a film to be polished (silicon oxide film) having irregularities, it is necessary to polish its convex regions selectively. In the case of using the polishing slurry of the invention, which contains a water-soluble polymer, the water-soluble polymer acts as a buffer between the cerium oxide particles and the film to be polished. In other words, the film to be polished in the concave regions, which receive a small effective polishing load, is protected; however, the film to be polished in the convex regions, which receive a large effective polishing load, is selectively polished since the water-soluble polymer is excluded. This way makes it possible to attain global planarization that is small in pattern-dependency.

Examples of the method for producing an inorganic insulated film to which the invention is applied include low-pressure CVD, and plasma CVD.

In the formation of a silicon oxide film by low-pressure CVD, out of these methods, monosilane: SiH₄ is used as a Si source and oxygen: O₂ is used as an oxygen source. The film is obtained when oxidizing reaction in this SiH₄-O₂ system is conducted at a low temperature of 400°C or lower. After the CVD, the resultant is subjected to thermal treatment at a temperature of 1000°C or lower as the case may be. When the resultant is doped with phosphorus: P in order to planarize the surface by high-temperature reflow, it is preferred to use a SiH₄-O₂-PH₃ based reactant gas.

In the meantime, plasma CVD has an advantage that a chemical reaction for which high temperature is required under ordinary thermal equilibrium can be conducted at low temperature. The method for generating plasma is classified into two type of the capacitively coupling type and the inductively coupling type. Examples of the reactant gas include SiH₄-N₂O based gas using SiH₄ as a Si source and using N₂O as an oxygen source, and TEOS-O₂ based gas using tetraethoxysilane (TEOS) as a Si source (TEOS-plasma CVD). The substrate temperature is preferably from 250 to 400°C, and the reaction pressure is preferably from 67 to 400 Pa.

As described above, the silicon oxide film to be polished may be doped with phosphorus, boron, or some other element. Similarly, in the formation of a silicon nitride film by low-pressure CVD, dichlorosilane: SiH₂Cl₂ is used as a Si source, and ammonia: NH₃ is used as a nitrogen source. The film can be obtained when oxidizing reaction in this SiH₂Cl₂-NH₃ system is conducted at a high temperature of 900°C. An example of the reactant gas in plasma CVD is a SiH₄-NH₃ based gas using SiH₄ as a Si source and using NH₃ as a nitrogen source. The substrate temperature is preferably from 300 to 400°C.

The CMP polishing slurry, the additive liquid and the polishing processes of the invention may be applied to not only a silicon oxide film formed on a semiconductor substrate but also producing processes of various electronic components, and others. For example, the following can be polished: an inorganic insulated film, such as a silicon oxide film, glass piece or silicon nitride that is formed on a wiring board having predetermined wiring; a film which mainly contains polysilicon, Al, Cu, Ti, TiN, W, Ta, TaN or the like; an optical glass such as a photomask, a lens, or a prism; an inorganic electroconductive film made of ITO or the like; an optical integrated circuit, optical switching circuit or optical waveguide that is composed of glass and a crystalline material, and an optical monocrystal such as an optical fiber end face or scintillator; a solid laser monocrystal, a sapphire substrate for a blue laser LED, and a semiconductor monocrystal such as SiC, GaP or GaAs; a glass substrate for a magnetic disc; and a magnetic head.

### Examples

The invention will be described in detail by the following examples.

### (Production of cerium oxide particles)

Into a vessel made of platinum was put 2 kg of cerium carbonate hydrate, and the carbonate was fired in the air at 800°C for 2 hours to yield 1 kg of a yellowish white powder. This powder was subjected to phase-identification according to X-ray diffraction analysis. As a result, it was verified that the powder was made of cerium oxide. The particle diameter of the fired powder was from 30 to 100 µm. The surface of the fired particles was observed with a scanning electron microscope. As a result, grain boundaries of cerium oxide were observed.

The diameter of cerium oxide primary particles surrounded by the grain boundaries was measured. As a result, the central value of the volume distribution was 190 nm, and the maximum value thereof was 500 nm. A jet mill was used to subject 1 kg of the cerium oxide powder to dry pulverization. The pulverized particles were observed with the scanning electron microscope. As a result, large post-pulverization-remaining particles of 1 to 3 µm size and post-pulverization-remaining particles of 0.5 to 1 µm size were intermingled besides small particles having sizes equivalent to those of the primary particles.

### (Synthesis of a water-soluble polymer)

### Synthesis Example 1

Into a 1-liter flask was charged 250 g of deionized water. While the water was stirred, the temperature thereof was set to 25°C. Thereafter, air caused to pass through a sintered filter so as to be made into fine air bubbles was introduced into the deionized water. Into the flask were dropwise added 200 g of acrylic acid and 300 g of a 35% solution of potassium hydrogensulfite in water over respective 4 hours. Heat generated by the polymerization reaction was cooled with cool water, and the temperature was kept at 25 to 28°C. After the addition, air was continuously blown into the solution for 1 hour, and then the content by percentage of nonvolatile matters was set to 40% by mass to yield a water-soluble polymer solution.

Furthermore, an aqueous GPC column (registered trade name: GEL PACK GL-W550, manufactured by Hitachi Chemical Co., Ltd.) was connected to an HPLC pump (L-7100, manufactured by Hitachi, Ltd.) provided with a differential refractometer (L-3300, manufactured by Hitachi, Ltd.), and 0.5mM-trisodium phosphate/acetonitrile (ratio by volume: 90/10) were used as a mobile phase to measure the molecular weight of the resultant water-soluble polymer. As a result, the weight-average molecular weight thereof was 4,400 (the value in terms of sodium polyacrylate).

### Synthesis Example 2

A water-soluble polymer solution was yielded in the same way as in Synthesis Example 1 except that 300 g of a 35% solution of potassium sulfite in water was used instead of 300 g of the 35% solution of potassium hydrogensulfite in water. The molecular weight was measured in the same way as in Synthesis Example 1. As a result, the weight-average molecular weight was 4, 600 (the value in terms of sodium polyacrylate).

### Synthesis Example 3

A water-soluble polymer solution was yielded in the same way as in Synthesis Example 1 except that 300 g of a 35% solution of sodium hydrogensulfite in water was used instead of 300 g of the 35% solution of potassium hydrogensulfite in water. The molecular weight was measured in the same way as in Synthesis Example 1. As a result, the weight-average molecular weight was 4, 300 (the value in terms of sodium polyacrylate).

### Synthesis Example 4

A water-soluble polymer solution was yielded in the same way as in Synthesis Example 1 except that 300 g of a 35% solution of sodium sulfite in water was used instead of 300 g of the 35% solution of potassium hydrogensulfite in water, and the components were added to the flask over respective 2 hours. The molecular weight was measured in the same way as in Synthesis Example 1. As a result, the weight-average molecular weight was 4, 500 (the value in terms of sodium polyacrylate).

### Example 1

### (Production of a polishing slurry)

Mixed were 1 kg of the cerium oxide particles, 23 g of the water-soluble polymer (polyacrylic acid) solution of synthesis Example 4, the pH of which was set to 8.3 with 50% potassium hydroxide, and 8977 g of deionized water. The mixture was subjected to ultrasonic dispersion for 10 minutes while stirred. The resultant slurry was filtrated through a 1-µm filter, and further deionized water was added thereto, so as to yield a 5% by mass slurry. The pH of the slurry was 8.9.

The slurry was diluted into an appropriate concentration, and a laser scattering type particle size distribution meter (product name: Master Sizer Microplus, manufactured by Malvern Co.) was used to measure the particles in the state that the refractive index and the absorption were set to 1.93 and 0, respectively. As a result, the central value of the particle diameters was 190 nm.

Mixed were 600 g of the cerium oxide slurry (solid content: 5% by mass), 22.5 g of the water-soluble polymer solution of Synthesis Example 1, and 2377.5 g of deionized water, and then the pH was adjusted to 5.0 with a 50% solution of potassium hydroxide in water to produce a cerium oxide based CMP polishing slurry (referred to as the cerium oxide polishing slurry hereinafter) wherein the solid content by percentage was 1% by mass.

The particles in the polishing slurry were diluted into an appropriate concentration, and then measured with the same laser scattering type particle size distribution meter as described above under the same conditions. As a result, the central value of the particle sizes was 190 nm.

Furthermore, the cerium oxide polishing slurry the solid content by percentage of which was adjusted to 1% by mass was subjected to centrifugation (at 8000 min⁻¹ for 1 hour) to remove cerium oxide. About the resultant supernatant, the amount of nitrogen therein was measured by use of an overall organism carbon meter TOC-V manufactured by Shimadzu Corp. As a result, the amount was 0.4 ppm.

### (Polishing of an insulated film)

As a test wafer for evaluating shallow trench isolating (STI) insulated film CMP, a 864 wafer (diameter: 200 nm) manufactured by Sematech was used. The trench depth was 500 nm, and the film thickness of the silicon nitride film formed on its active region by LP-CVD was 150 nm, and the film thickness of the silicon oxide film (HDP-SiO), which was formed on the whole of the wafer by SiH₄-high density plasma CVD, was 600 nm.

The evaluating wafer was set to a holder of a polishing machine (product name: Mirra, manufactured by Applied Material Co.), an adsorbing pad for setting a substrate to be held being attached to the holder, while a polishing pad (model number: IC-1000 (K grooves)) made of a porous urethane resin manufactured by Rohm & Haas Nitta Co. was attached to a polishing table having a diameter of 480 mm.

The holder was put on the pad to face its insulated film surface downwards. Furthermore, the membrane pressure, the retainer ring pressure and the inner tube pressure were set to 3.0 psi, 3.5 psi, and 3.0 psi (20.9 kPa, 24.1 kPa, and 20.9 kPa), respectively, as working loads. While the cerium oxide polishing slurry prepared as described above was dropped onto the table at a speed of 200 mL/min, the table and the wafer were moved at 98 min⁻¹, and 78 min⁻¹, respectively, to polish the test wafer for evaluating STI insulated film CMP.

By monitoring the torque current value of the polishing table, the end point of the polishing was detected. The polished wafer was sufficiently washed with pure water, and dried. Thereafter, a light interference type film thickness meter (registered trade name: Nanospec, AFT-5100, manufactured by Nanometrics Inc.) was used to measure the thickness of the rest of the insulated film in the concave regions, the thickness of the rest of the insulated film in the convex regions, or the thickness of the rest of the silicon nitride film. The polishing amount was decided from the difference between the initial film thickness and the thickness of the rest of the film. Furthermore, a step height meter, Dektak V2000-Si, manufactured by Veeco Co. was used to measure the remaining step height between the convex regions and the concave regions after the polishing. The results are shown in Table 1.

### Example 2

A cerium oxide polishing slurry was prepared and evaluated in the same way as in Example 1 except that instead of the solution of Synthesis Example 1, the solution of Synthesis Example 2 having the same mass was used as the additive liquid for CMP polishing slurry. The pH of the polishing slurry was 5.0. The diameters of particles in the polishing slurry were measured in the same way as in Example 1. As a result, the central value of the particle diameters was 190 nm in all cases. The nitrogen content was 0.3 ppm. Thereafter, the insulated film layer was polished in the same way as in Example 1. After the polishing, the remaining step height between the convex regions and the concave regions was measured. The results are shown in Table 1.

### Example 3

A cerium oxide polishing slurry was prepared and evaluated in the same way as in Example 1 except that instead of the solution of Synthesis Example 1, the solution of Synthesis Example 3 having the same mass was used as the additive liquid for CMP polishing slurry. The pH of the polishing slurry was 5.0. The diameters of particles in the polishing slurry were measured in the same way as in Example 1. As a result, the central value of the particle diameters was 190 nm in all cases. The nitrogen content was 0.4 ppm. Thereafter, the insulated film layer was polished in the same way as in Example 1. After the polishing, the remaining step height between the convex regions and the concave regions was measured. The results are shown in Table 1.

### Example 4

A cerium oxide polishing slurry was prepared and evaluated in the same way as in Example 1 except that instead of the solution of Synthesis Example 1, the solution of Synthesis Example 4 having the same mass was used as the additive liquid for CMP polishing slurry. The pH of the polishing slurry was 5.0. The diameters of particles in the polishing slurry were measured in the same way as in Example 1. As a result, the central value of the particle diameters was 190 nm in all cases. The nitrogen content was 0.4 ppm. Thereafter, the insulated film layer was polished in the same way as in Example 1. After the polishing, the remaining step height between the convex regions and the concave regions was measured. The results are shown in Table 1.

### Comparative Example 1

### (Synthesis of a water-soluble polymer)

Synthesis Example 5 Into a 1-liter flask were charged 180 g of deionized water and 180 g of 2-propanol. While the liquid was stirred, the temperature thereof was raised to 85°C. Thereafter, in the atmosphere of nitrogen, a mixture wherein 300 g of acrylic acid, 6 g of 2, 2' -azobisisobutyronitrile, and 94 g of methanol were mixed to dissolve the solid component was dropwise added into the flask over 4 hours.

Next, the system was kept at 85°C for 1 hour, and then cooled to adjust the nonvolatile matter content to 40% by mass. The matter was taken out to yield a water-soluble polymer solution.

In the same way as in Synthesis Example 1, the molecular weight of the resultant water-soluble polymer was measured. As a result, the weight-average molecular weight thereof was 12,000 (the value in terms of sodium polyacrylate).

### (Production of a polishing slurry)

A cerium oxide polishing slurry (solid content: 1% by mass) was produced in the same way as in Example 1 except that 22.5 g of the water-soluble polymer solution of Synthesis Example 5 was used instead of the solution in Synthesis Example 1.

The diameter of the particles in the polishing slurry was measured in the same way as in Example 1. As a result, the central value of the particle diameters was 190 nm in all cases. The nitrogen content was 13.2 ppm.

The insulated film layer was polished in the same way as in Example 1. After the polishing, the remaining step height between the convex regions and the concave regions was measured. The results are shown in Table 1.

**[Table 1]**

| Items | | | Examples | | | | Comparative Example 1 |
|---|---|---|---|---|---|---|---|
| | | | 1 | 2 | 3 | 4 | |
| Cerium oxide blend amount (% by mass) | | | 1.0 | 1.0 | 1.0 | 1.0 | 1.0 |
| Water -soluble polymer | Synthesis Example | | 1 | 2 | 3 | 4 | 5 |
| | Polymerization initiator | | Potassium hydrogen sulfite | Potassium sulfite | Sodium hydrogen sulfite | Sodium sulfite | 2,2'-Azobis isobutyro nitrile |
| | Weight-average molecular weight | | 4,400 | 4,600 | 4,300 | 4,500 | 12,000 |
| | Addition amount (% by mass) | | 0.3 | 0.3 | 0.3 | 0.3 | 0.3 |
| Polishing period for making the SiN film naked in 70%-convex-region portions (seconds) | | | 110 | 115 | 105 | 110 | 170 |
| Convex region SiN-remaining film thickness (nm) | | Convex regions: 70% | 152 | 150 | 149 | 151 | 150 |
| | | Convex regions: 10% | 141 | 142 | 143 | 143 | 134 |
| | | Remaining film thickness difference | 11 | 8 | 6 | 8 | 16 |
| Concave region SiO₂-remaining film thickness (nm) | | Convex regions: 70% | 478 | 477 | 479 | 479 | 472 |
| | | Convex regions: 10% | 436 | 429 | 441 | 438 | 319 |
| | | Remaining film thickness difference | 42 | 48 | 38 | 41 | 153 |
| Nitrogen content in supernatant(ppm in polishing slurry not used for polishing) | | | 0.4 | 0.3 | 0.4 | 0.4 | 13.2 |

As shown in Table 1, the CMP polishing slurries prepared in Examples 1 to 4 were each used to polish an evaluating wafer. As a result, in high-density portions (convex regions: 70%) thereof, the SiO₂ film in the convex regions was completely polished in 105 to 115 seconds to make the SiN film naked. The thickness of the SiN film remaining in the convex regions was from 149 to 152 nm, and the thickness of the SiO₂ film remaining in the concave regions was from 477 to 479 nm.

In low-density portions (convex regions: 10%) thereof, the thickness of the SiN film remaining in the convex regions was from 141 to 143 nm, and the thickness of the SiO₂ film remaining in the concave regions was from 429 to 441 nm.

The difference in the convex region SiN-remaining film thickness between the high-density portions (convex regions: 70%) and the low-density portions (convex regions: 10%) was from 6 to 11 nm, and the difference in the concave region SiO₂-remainin film thickness therebetween was from 38 to 48 nm. Thus, even polishing, in which the effect of the pattern density difference was small, was attained.

An optical microscope was used to observe the polished insulated film surfaces. As a result, in each of Examples, a clear polished scratch was not observed.

On the other hand, the CMP polishing slurry prepared in Comparative Example was used to polish an evaluating wafer; as a result, in order to make the convex region SiN film in the high-density portions (convex regions: 70%) thereof naked, a period of 170 seconds was required, as shown in Table 1.

In low-density portions (convex regions: 10%) thereof, the thickness of the SiN film remaining in the convex regions was 134 nm, and the thickness of the SiO₂ film remaining in the concave regions was 319 nm. The difference in the convex region SiN-remaining film thickness between the high-density portions (convex regions: 70%) and the low-density portions (convex regions: 10%) was 16 nm, and the difference in the concave region SiO₂-remaining film thickness therebetween was 153 nm. Thus, an effect of the pattern density difference was generated, so that the polishing advanced unevenly.

The nitrogen content in the polishing slurries of Examples, which was from 0. 3 to 0. 4 ppm, was far lower than that of Comparative Example, which was 13.2 ppm. Thus, Examples can cope with an end-point detector based on the detection of ammonia.

According to the experimental results, Examples 1 to 4 make it possible to attain even polishing, wherein the effect of the difference between pattern densities is small, and to cope with an end-point detector based on the detection of ammonia since the nitrogen content is also low.

### Industrial Applicability

According to the invention, it is possible to provide a CMP polishing slurry and an additive liquid for CMP polishing slurry that make it possible that in CMP technique for planarizing an interlayer dielectric, a BPSG film, an insulated film for shallow trench element isolation or others, a silicon oxide film or the like is evenly polished at a high rate without giving any polished scratch and further the process is easily controlled; and substrate-polishing processes using the same.

## Claims

1. A CMP polishing slurry, comprising cerium oxide particles, a dispersing agent, a water-soluble polymer and water, wherein the water-soluble polymer includes a polymer obtained by polymerizing a monomer including at least one of a carboxylic acid having an unsaturated double bond and a salt thereof, using a reducing inorganic acid salt and oxygen as a redox polymerization initiator.

2. The CMP polishing slurry according to claim 1, wherein the reducing inorganic acid salt is a sulfite.

3. The CMP polishing slurry according to claim 1 or 2, wherein the blend amount of the water-soluble polymer is 0.01 part or more by mass to 5 parts or less by mass for 100 parts by mass of the CMP polishing slurry.

4. The CMP polishing slurry according to any one of claims 1 to 3, wherein the weight-average molecular weight of the water-soluble polymer is 200 or more to 50,000 or less.

5. The CMP polishing slurry according to any one of claims 1 to 4, wherein at least one of the dispersing agent and the water-soluble polymer is a compound having in the molecule thereof no nitrogen.

6. The CMP polishing slurry according to any one of claims 1 to 5, wherein the nitrogen content in the polishing slurry is 10 ppm or less.

7. The CMP polishing slurry according to claim 5 or 6, which is used to detect the end point of polishing on the basis of the generation of ammonia.

8. The CMP polishing slurry according to any one of claims 1 to 7, wherein the carboxylic acid having an unsaturated double bond and the salt thereof include at least one selected from acrylic acid, methacrylic acid, and salts thereof.

9. The CMP polishing slurry according to any one of claims 1 to 7, wherein the carboxylic acid having an unsaturated double bond and the salt thereof include acrylic acid or a salt thereof.

10. The CMP polishing slurry according to any one of claims 1 to 7, wherein the carboxylic acid having an unsaturated double bond and the salt thereof are acrylic acid or a salt thereof.

11. An additive liquid for CMP polishing slurry, comprising a water-soluble polymer and water, wherein the water-soluble polymer includes a polymer obtained by polymerizing a monomer including at least one of a carboxylic acid having an unsaturated double bond and a salt thereof, using a reducing inorganic acid salt and oxygen as a redox polymerization initiator.

12. The additive liquid for CMP polishing slurry according to claim 11, wherein the reducing inorganic acid salt is a sulfite.

13. The additive liquid for CMP polishing slurry according to claim 11 or 12, wherein the weight-average molecular weight of the water-soluble polymer is 200 or more to 50,000 or less.

14. The additive liquid for CMP polishing slurry according to any one of claims 11 to 13, wherein the carboxylic acid having an unsaturated double bond and the salt thereof include at least one selected from acrylic acid, methacrylic acid, and salts thereof.

15. The additive liquid for CMP polishing slurry according to any one of claims 11 to 13, wherein the carboxylic acid having an unsaturated double bond and the salt thereof include acrylic acid or a salt thereof.

16. The additive liquid for CMP polishing slurry according to any one of claims 11 to 13, wherein the carboxylic acid having an unsaturated double bond and the salt thereof are acrylic acid or a salt thereof.

17. A substrate-polishing process, wherein a substrate on which a film to be polished is formed is pushed and pressed against a polishing cloth of a polishing table, and a CMP polishing slurry as recited in any one of claims 1 to 10 is supplied to between the film to be polished and the polishing cloth while the substrate and the polishing table are relatively moved, thereby polishing the film to be polished.

18. A substrate-polishing process, wherein a substrate on which a film to be polished is formed is pushed and pressed against a polishing cloth of a polishing table, a cerium oxide slurry comprising cerium oxide particles, a dispersing agent and water is mixed with an additive liquid for CMP polishing slurry as recited in any one of claims 11 to 16 to yield a CMP polishing slurry, and the CMP polishing slurry is supplied to between the film to be polished and the polishing cloth while the substrate and the polishing table are relatively moved, thereby polishing the film to be polished.

19. The substrate-polishing process according to claim 17 or 18, comprising the step of detecting ammonia generated by polishing a nitride, thereby deciding the end point of the polishing.
